# EUROPÄISCHE PATENTSCHRIFT

(11) **EP 0 303 819 B1**
(45) Veröffentlichungstag und Bekanntmachung des Hinweises auf die Patenterteilung: **28.09.1994**
(21) Anmeldenummer: 88111056.3
(22) Anmeldetag: 11.07.1988
(51) Int. Cl.: H04N 1/18, H04N 1/028

(54) **Integrierte Schaltung zum Auslesen eines optoelektronischen Bildsensors**
Integrated circuit for reading out an optoelectronic image sensor
Circuit intégré pour la lecture d'un capteur d'image opto-électronique

(30) Priorität: 21.08.1987 DE 3727943
(43) Veröffentlichungstag der Anmeldung: 22.02.1989
(73) Patentinhaber: Heimann Optoelectronics GmbH, D-65199 Wiesbaden (DE)
(72) Erfinder: Brunst, Gerhard, Dr. rer. nat., D-8000 München 40 (DE); Rohleder, Klaus, Dipl.-Ing., D-8000 München 83 (DE)
(74) Vertreter: Beetz & Partner Patentanwälte

(56) Entgegenhaltungen:
- EP-A- 0 053 946
- EP-A- 0 060 149
- EP-A- 0 067 925
- EP-A- 0 176 290
- DE-A- 3 236 524
- GB-A- 2 092 785
- PATENT ABSTRACTS OF JAPAN, Band 012-013 (E-573), 14. Januar 1988;& JP-A-62 171 373 (CANON INC.)
- PATENT ABSTRACTS OF JAPAN, Band 011-099 (E-493), 27. März 1987;& JP-A-61 251 168 (SEKO EPSON CORP.)
- IEDM TECHNICAL DIGEST, INTERNATIONAL ELECTRON DEVICES MEETING, Washington, 1.-4. Dezember 1985, Seiten 436-439; H. ITO: "a-Si:H TFT array driven linear image sensor with capacitance coupling isolation structure"
- IEEE TRANSACTIONS ON COMPONENTS, HYBRIDS AND MANUFACTURING TECHNOLOGY, Band CHMT-9, Nr. 3, September 1986, Seiten 304-309, New York, US; K. SEKI et al.: "Analysis and design of a large-scale linear image sensor using amorphous silicon"

## Beschreibung

Die Erfindung bezieht sich auf eine integrierte Schaltung zum Auslesen eines optoelektronischen Bildsensors nach dem Oberbegriff des Patentanspruchs 1. Eine solche integrierte Schaltung ist aus der JP-A-62 171 373 (CANON INC.) bekannt.

Diese Druckschrift beschreibt eine integrierte Schaltung zum Auslesen eines optoelektronischen Bildsensors, der m Gruppen von jeweils n nebeneinander angeordneten, über ihre ersten Anschlüsse mit einem konstanten Potential beschaltbaren Sensorelemente aufweist, bei der die zweiten Anschlüsse der Sensorelemente über Datenleitungen mit den Eingängen einer Ausleseschaltung verbindbar sind, bei der in Serie zu jedem Sensorelement ein Schalttransistor angeordnet ist und bei der die Ausleseschaltung die Sensorsignale aller Sensorelemente sequentiell an einen Ausgang überträgt, wobei die n Sensorelemente jeder Gruppe über die in Serie zu ihren zweiten Anschlüssen angeordneten Schalttransistoren einzeln nacheinander an eine gemeinsame, gruppenspezifische Datenleitung anschaltbar sind, ihre ersten Anschlüsse ständig mit dem konstanten Potential belegt sind, wobei die Ausleseschaltung m Eingänge hat, die mit m gruppenspezifischen Datenleitungen beschaltet sind und wobei die Schalttransistoren derjenigen Sensorelemente unterschiedlicher Gruppen, die innerhalb ihrer Gruppe jeweils gleiche Ordnungszahlen aufweisen, über eine gemeinsame Steuerleitung ansteuerbar sind, so daß den Eingängen der Ausleseschaltung ein Signalbündel von m Sensorsignalen aller Sensorelemente gleicher Ordnungszahlen gleichzeitig und in n aufeinanderfolgenden Zeitabschnitten jeweils entsprechende Signalbündel, die zu unterschiedlichen Ordnungszahlen gehören, zugeführt werden.

Die EP-A-0 053 946 beschreibt eine Dünnschicht-Leseeinheit mit einem Substrat, einer Metallelektrode, Streifen aus photoleitendem Material und einer transparenten Elektrode.

Der Erfindung liegt die Aufgabe zugrunde, eine integrierte Schaltung der eingangs genannten Art anzugeben, die in einfacher Weise hergestellt werden kann und bei der die Zahl der Überkreuzungen der Datenleitungen untereinander gegenüber den herkömmlichen Anordnungen stark reduziert ist. Das wird erfindungsgemäß durch eine Ausbildung nach dem kennzeichnenden Teil des Patentanspruchs 1 erreicht.

Der mit der Erfindung erzielbare Vorteil liegt insbesondere darin, daß bei der Herstellung der integrierten Schaltung eine hohe Ausbeute erreicht wird und daß die parasitären Kapazitäten zwischen den Datenleitungen stark reduziert sind, so daß den Eingängen der Ausleseschaltung größere Sensorsignale zugeführt werden können, als dies bei den vergleichbaren herkömmlichen Schaltungen der Fall ist. Außerdem werden störende gegenseitige Beeinflussungen der Signale auf den Datenleitungen und auf den Steuerleitungen weitgehend vermieden.

Vorteilhafte Ausgestaltungen und Weiterbildungen der Erfindung sind in den Patentansprüchen 2 bis 4 angegeben.

Die Erfindung wird nachfolgend anhand von in der Zeichnung dargestellten, bevorzugten Ausführungsbeispielen näher erläutert. Dabei zeigt:
- Fig. 1: ein erstes Ausführungsbeispiel der Schaltung nach der Erfindung,
- Fig. 2: eine beispielsweise Ausführungsform der Schaltung nach Fig. 1,
- Fig. 3: ein zweites Ausführungsbeispiel der Erfindung, bei dem die Schalttransistoren in anderer Weise angesteuert sind,
- Fig. 4: ein drittes Ausführungsbeispiel der Erfindung, bei dem die Ansteuerung der Schalttransistoren wieder in anderer Weise erfolgt,
- Fig. 5: ein viertes Ausführungsbeispiel der Erfindung, bei dem die Schalttransistoren in unterschiedlicher Weise angeordnet sind,
- Fig. 6: ein fünftes Ausführungsbeispiel der Erfindung, das eine schnellere Auslesung des Bildsensors ermöglicht, und
- Figur 7: das Prinzipschaltbild einer Zusatzschaltung, die der in den Figuren 1 und 3 bis 6 vorgesehenen Ausleseschaltung nachgeordnet ist.

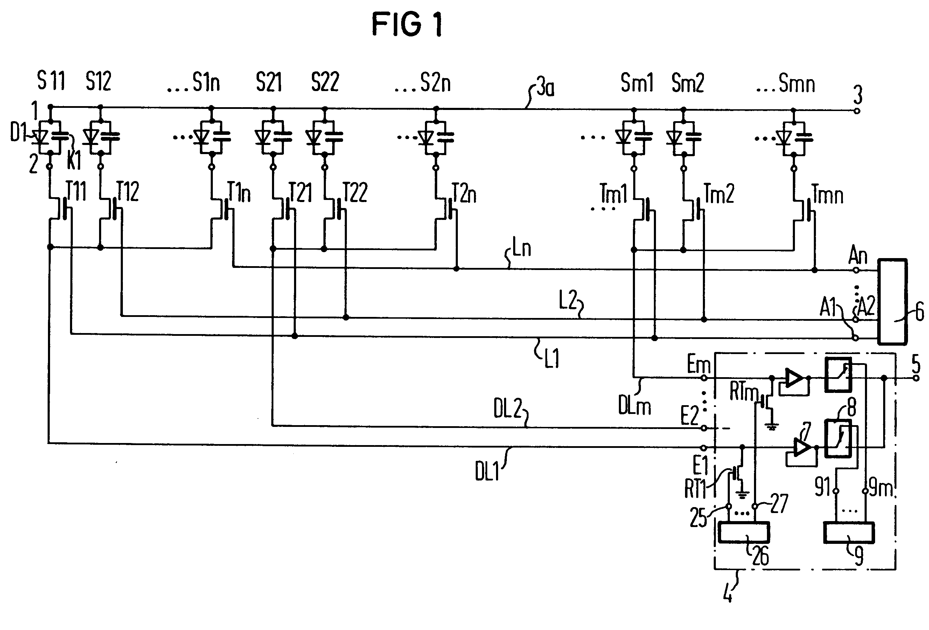

In Figur 1 sind die nebeneinander liegenden Sensorelemente eines linearen optoelektronischen Bildsensors mit S11 bis Smn bezeichnet. Das erste Sensorelement S11 weist eine zwischen den Anschlüssen 1 und 2 liegende Photodiode D1 auf, sowie eine die Kapazität des Sensorelements darstellende Kapazität K1, die zu D1 parallelgeschaltet ist. Über den Anschluß 1 wird das Sensorelement S11 mit einem konstanten Potential beaufschlagt, das durch eine Konstantspannung - U₀ gegeben ist, die an einem allen Sensorelementen gemeinsamen Anschluß 3 liegt und über eine Zuleitung 3a herangeführt wird. Der Anschluß 2 ist über die Source-Drain-Strecke eines Schalttransistors T11 und über eine Datenleitung DL1 mit dem ersten Eingang E1 einer Ausleseschaltung 4 verbunden. Das Gate von T11 wird dabei über eine Steuerleitung L1 angesteuert, die an den Ausgang A1 eines Schieberegisters 6 gelegt ist.

Die übrigen Sensorelemente S12 bis Smn, die in ihrem Aufbau dem beschriebenen Sensorelement S11 entsprechen, sind über im einzelnen nicht bezeichnete erste Anschlüsse an den gemeinsamen Anschluß 3 gelegt. Ihre zweiten Anschlüsse sind jeweils über die Source-Drain-Strecken von zugeordneten Schalttransistoren T12 bis Tmn in einer noch näher zu bezeichnenden Weise mit der Datenleitung DL1 und weiteren Datenleitungen DL2 bis DLm verbunden, die an die weiteren Eingänge E2 bis Em der Auslesenschaltung 4 geschaltet sind. Die Gates von T12 bis Tmn sind in einer ebenfalls noch näher zu beschreibenden Weise mit der Steuerleitung L1 und weiteren Steuerleitungen L2 bis Ln beschaltet, die an weiteren Ausgängen A2 bis An des Schieberegisters 6 liegen.

Die ersten n Sensorelemente S11 bis S1n sind zu einer ersten Gruppe zusammengefaßt, wobei ihre zweiten Anschlüsse über die Schalttransistoren T11 bis T1n mit der Datenleitung DL1 verbunden sind, die eine allen Sensorelementen dieser Gruppe gemeinsame, gruppenspezifische Datenleitung darstellt. Die nächsten n Sensorelemente S21 bis S2n sind zu einer zweiten Gruppe zusammengefaßt, wobei ihre zweiten Anschlüsse über T21 bis T2n mit der zugeordneten, gruppenspezifischen Datenleitung DL2 verbunden sind. In analoger Weise sind auch die nachfolgenden Sensorelemente zu Gruppen von jeweils n Sensorelementen zusammengefaßt und mit jeweils einer gruppenspezifischen Datenleitung verbunden. Die letzte, aus Sm1 bis Smn bestehende Gruppe ist mit der gruppenspezifischen Datenleitung DLm beschaltet. Die Steuerleitung L1 ist mit den Gates derjenigen Schalttransistoren T11, T21...Tm1 verbunden, die zu den jeweils ersten Sensorelementen aller Gruppen, das heißt zu S11, S21...Sm1, gehören. Die Steuerleitung L2 liegt an den Gates der Schalttransistoren T12, T22 bis Tm2. Schließlich steht die Steuerleitung Ln mit den Gates der Schalttransistoren T1n, T2n bis Tmn in Verbindung. Ganz allgemein sind über jede der Steuerleitungen L1 bis Ln alle jene Schalttransistoren aller m Gruppen von Sensorelementen ansteuerbar, die innerhalb der einzelnen Gruppen jeweils die gleiche Ordnungszahl aufweisen.

Im einzelnen werden über L1 in einem ersten Zeitabschnitt alle Schalttransistoren T11 bis Tm1 gleichzeitig leitend geschaltet, so daß die von S11, S21...Sm1 abgegebenen Sensorsignale gleichzeitig, das heißt in Form eines Signalbündels, an die Eingänge E1 bis Em der Ausleseschaltung 4 gelegt werden. In einem sich anschließenden zweiten Zeitabschnitt werden alle Schalttransistoren T12 bis Tm2 über L2 leitend geschaltet, so daß den Eingängen E1 bis Em ein zweites Signalbündel zugeführt wird, das aus den Sensorsignalen von S12 bis Sm2 besteht. In weiteren Zeitabschnitten werden entsprechende Signalbündel von Sensorelementen mit jeweils steigender, aber gleicher Ordnungszahl innerhalb der Gruppen abgeleitet, wobei im n'ten Zeitabschnitt die m Sensorsignale der Sensorelemente S1n bis Smn über die dann leitenden Transistoren T1n bis Tmn an die Eingänge der Ausleseschaltung 4 gelegt werden. Die Ansteuerung der Schalttransistoren T11 bis Tmn erfolgt dabei in der Weise, daß während des ersten Zeitabschnitts über den Ausgang A1 des Schieberegisters 6 eine "1" abgegeben wird, während die übrigen Ausgänge A2 bis An jeweils mit einer "0" belegt sind. Im zweiten Zeitabschnitt wird lediglich über A2 eine "1" abgegeben usw. bis schließlich innerhalb des n'ten Zeitabschnitts an An eine "1" anliegt, während alle übrigen Ausgänge von 6 mit einer "0" belegt sind.

Die Ausleseschaltung 4 ist so ausgebildet, daß innerhalb jedes einzelnen der genannten Zeitabschnitte sämtliche Sensorsignale des anliegenden Signalbündels einzeln nacheinander an einen Ausgang 5 durchgeschaltet werden. Hierbei wird zunächst das an E1 anliegende Sensorsignal durchgeschaltet und zuletzt das am Eingang Em anliegende. Jeder Eingang, zum Beispiel E1, von 4 ist mit dem positiven Eingang eines Differenzverstärkers, zum Beispiel 7, beschaltet, dessen Ausgang einerseits mit seinem negativen Eingang verbunden ist und andererseits über eine Abtaststufe, zum Beispiel 8, an den Ausgang 5 geführt ist. Ein Schieberegister 9 steuert über seine Parallelausgänge 91 bis 9m die genannten Abtaststufen so an, daß zunächst durch ein "1"-Signal am Ausgang 91 die Abtaststufe 8 den Ausgang von 7 auf den Ausgang 5 durchschaltet, während alle übrigen Abtaststufen durch an den Ausgängen 92 bis 9m liegende "0"-Signale gesperrt sind. Anschließend werden die weiteren Ausgänge von 9 und zuletzt der Ausgang 9m jeweils einzeln nacheinander mit einer "1" belegt, wobei über die zugeordneten Abtaststufen die an den Eingängen E2 bis Em liegenden Sensorsignale sequentiell an den Ausgang 5 gelangen. Die sequentielle Durchschaltung der eingangsseitigen Signale wiederholt sich in jedem der obengenannten Zeitabschnitte.

Die Ausleseschaltung 4 enthält noch Rücksetztransistoren, die mit ihren Source-Drain-Strecken die Eingänge E1 bis Em jeweils wahlweise mit dem Bezugspotential der Schaltung verbinden. In Figur 1 ist der dem Eingang E1 zugeordnete Rücksetztransistor mit RT1 bezeichnet, der Em zugeordnete mit RTm. Dabei ist das Gate von RT1 mit dem ersten Ausgang 25 eines Schieberegisters 26 beschaltet, während die Gates der weiteren, den Eingängen E2 bis Em zugeordneten Rücksetztransistoren mit den weiteren Ausgängen von 26 beschaltet sind. Das Gate von RTm liegt dabei am letzten Ausgang 27 des Schieberegisters 26. Lediglich einer der Ausgänge, zum Beispiel 25, ist jeweils mit einer "1" belegt, während alle übrigen Ausgänge eine "0" aufweisen. In Abhängigkeit von zugeführten Taktspannungen wird die "1" schrittweise vom ersten Ausgang 25 zum letzten Ausgang 27 hin verschoben.

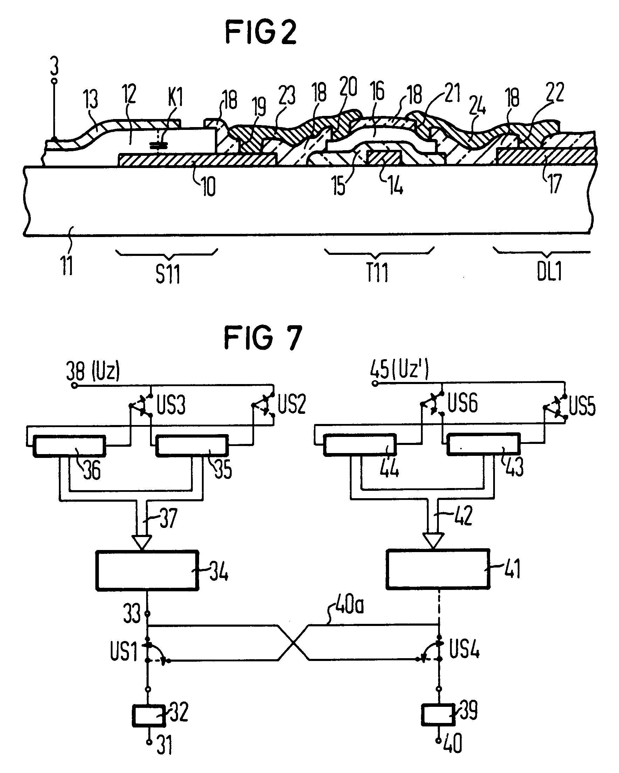

Figur 2 zeigt den Querschnitt des Sensorelements S1 sowie des zugeordneten Schalttransistors T11 und eines Teils der angeschlossenen Datenleitung DL1, die auf einem Substrat integriert sind. S11 weist dabei eine metallische Elektrode 10, zum Beispiel aus Cr, auf, die auf einem isolierenden Substrat 11, zum Beispiel aus Glas, aufgedampft ist. Die Elektrode 10 wird von einer Schicht 12 aus amorphem Silizium überdeckt, die insbesondere aus a-Si:H besteht. Über dieser befindet sich eine transparente Elektrode 13, zum Beispiel eine ITO-Elektrode. Die Kapazität zwischen den Teilen 10 und 13 wird durch K1 dargestellt. Beispielsweise sind die Schicht 12 und die Elektrode 13 streifenförmig ausgebildet und allen Sensorelementen gemeinsam zugeordnet. Die Elektrode 13 ist mit dem Anschluß 3 (Figur 1) versehen, der mit der Konstantspannung -U₀ beschaltet ist. Der Schalttransistor T11 ist mit Vorteil als Dünnfilmtransistor ausgebildet und besteht im einzelnen aus einer auf 11 aufgedampften Gateelektrode 14, die durch eine Gateisolierungsschicht 15 von einer darüberliegenden amorphen Siliziumschicht 16 getrennt ist. Letztere bildet das Source-, Drain- und Kanalgebiet des Schalttransistors. Eine auf dem Substrat 11 aufgedampfte Leiterbahn 17 stellt die Datenleitung DL1 dar. Die Teile 12, 16 und 17 sind durch eine Zwischenisolierungsschicht 18 abgedeckt, die mit Kontaktlöchern 19 bis 22 versehen ist. Eine erste, auf der Schicht 18 aufgebrachte leitende Belegung 23 kontaktiert im Bereich der Kontaktlöcher 19 und 20 jeweils die Teile 10 und 16, eine zweite leitende Belegung 24 im Bereich der Kontaktlöcher 21 und 22 die Teile 16 und 17. Ein solches Sensorelement entspricht in seinem Aufbau etwa dem in der erwähnten Literaturstelle IEDM 85, Seiten 436 bis 439, beschriebenen und in Figur 2 auf Seite 437 dargestellten Sensorelement. Sämtliche in Figur 1 dargestellten Schaltungsteile sind zweckmäßigerweise auf dem Substrat 11 integriert.

Die Wirkungsweise des Bildsensors nach Figur 1 ist wie folgt: Betrachtet man das Sensorelement S11, so wird dessen Kapazität K1 zunächst bei Leitendschaltung von T11 und RT1, das heißt beim Auftreten von "1"-Signalen an den Ausgängen A1 und 25, auf die bei 3 anliegende Spannung -U₀ aufgeladen. Nach Beendigung dieser Aufladephase wird T11 gesperrt. Mit dieser Sperrung beginnt eine Entladephase, in der sich K1 über die Photodiode D1 teilweise entlädt. Die Entladung erfolgt mittels des über D1 fließenden Stromes, dessen Größe von der Intensität des auf S11 auftreffenden Lichtes abhängt. Bei kleiner Intensität des einfallenden Lichtes ist dieser Strom klein, so daß sich nach Beendigung der zum Beispiel 1 ms betragenden Entladephase die Ladung von K nur um einen kleinen Betrag verringert hat. Je stärker die Intensität des einfallenden Lichtes ist, umsomehr kann sich K während der in ihrer zeitlichen Dauer festgelegten Entladephase auch tatsächlich entladen. Am Ende der Entladephase wird T11 wieder leitend geschaltet und RT1 gesperrt, wobei das am Anschluß 2 liegende Sensorsignal, das ohne jede Entladung von K1 ein Nullsignal darstellt und sich mit größer werdender Entladung von K1 immer mehr einem Signalwert von -U₀ annähert, über DL1 auf den Eingang E1 übertragen wird. Das an E1 anliegende Sensorsignal wird im Verstärker 7 verstärkt und über die vom Ausgang 91 angesteuerte Abtaststufe 8 an den Ausgang 5 übertragen. Nach der Übernahme des am Anschluß 2 abgegriffenen Sensorsignals durch die Abtaststufe 8 und der anschließenden Sperrung von 8 wird bei weiterhin leitendem Transistor T11 auch der Rücksetztransistor RT1 wieder leitend geschaltet, so daß eine neue Ladephase von S11 beginnt. Diese wird durch eine nachfolgende Sperrung von T11 beendet, mit der dann eine weitere Entladephase beginnt. Durch die nächste Leitendschaltung von T11 sowie Sperrung von RT1 wird dann diese Entladephase beendet und ein in S11 während dieser Entladephase gebildetes Sensorsignal ausgelesen. T11 ist jeweils sowohl während des Auslesens der zuvor gebildeten Sensorsignals als auch während der sich anschließenden Aufladephase leitend geschaltet und bleibt dann jeweils während der Bildung eines neuen Sensorsignals gesperrt. Während der Sperrung von T11, das heißt während der Entladephase von K1, werden alle übrigen Schalttransistoren T12 bis T1n, die sich mit S11 in einer Gruppe befinden, einzeln nacheinander leitend geschaltet, um jeweils während ihrer Leitendschaltung das Auslesen der in den ihnen zugeordneten Sensorelementen S12 bis S1n in den vorangegangenen Entladephasen gebildeten Sensorsignale sowie das Rücksetzen dieser Sensorelemente zu ermöglichen. Unter Beachtung der vorstehend erwähnten, gegenseitigen zeitlichen Versetzung erfolgt die erwähnte Aufladung der Kapazitäten der Sensorelemente S11 bis S1n, die sich anschließende Bildung der Sensorsignale in den Entladephasen, die Auslesung der Sensorsignale und die neuerliche Aufladung der Kapazitäten für alle diese Sensorelemente in jeweils gleicher Weise durch wiederholtes gegeneinander zeitlich versetztes Umschalten der Schalttransistoren T11 bis T1n sowie der Rücksetztransistoren RT1 bis RTm aus dem sperrenden in den leitenden Zustand und umgekehrt.

Der vorstehend beschriebene Ablauf des Bildens und Auslesens der einzelnen Sensorsignale in den bzw. aus den Sensorelementen S11 bis S1n der ersten Gruppe findet gleichzeitig in analoger Weise auch in jeder der übrigen Gruppen von Sensorelementen statt, wobei die zuerst ausgelesenen Sensorsignale aller Gruppen, die von S11, S21 bis Sm1 abgeleitet werden, das erste Signalbündel bilden, die anschließend ausgelesenen Sensorsignale aller Gruppen, die von S12, S22 bis Sm2 abgeleitet werden, das zweite Signalbündel, usw.

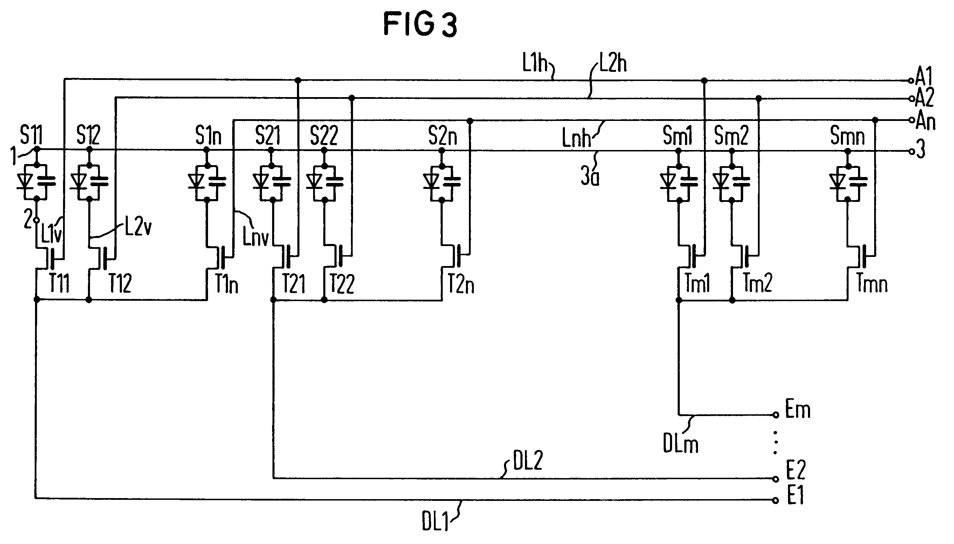

Figur 3 zeigt ein zweites Ausführungsbeispiel der Erfindung, das sich nur durch eine unterschiedliche Ansteuerung der Schalttransistoren T11 bis Tmn von Figur 1 unterscheidet. Hierbei sind die Steuerleitungen L1 bis Ln und die Datenleitungen DL1 bis DLm durch die Reihe der Sensorelemente S11 bis Smn voneinander getrennt, soweit diejenigen Stücke dieser Leitungen betroffen sind, die parallel zu der Reihe der Sensorelemente verlaufen und zu den Eingängen E1 bis Em der Ausleseschaltung 4 oder zu den Ausgängen A1 bis An des Schieberegisters 6 hinführen. Wie Figur 3 im einzelnen erkennen läßt, umfassen die Steuerleitungen L1 bis Ln jeweils kurze, senkrecht zur Sensorelementenreihe verlaufende, das heißt vertikale Leitungsstücke, zum Beispiel L1v, L2v bis Lnv, die so bemessen sind, daß ihre oberen Enden in Figur 3 oberhalb der Zuleitung 3a liegen, die den gemeinsamen Anschluß 3 mit den ersten Anschlüssen 1 der einzelnen Sensorelemente verbindet. Die vertikalen Leitungsstücke, die die Zuleitung 3a überkreuzen, sind durch eine Isolierschicht von dieser getrennt. Geht man dabei von einer Ausführung der Sensorelemente gemäß Figur 2 aus, so besteht die Zuleitung 3a aus der streifenförmigen Elektrode 13. Von den oberen Enden der vertikalen Leitungsstücke, zum Beispiel L1v bis Lnv, gelangt man über horizontal verlaufende Leitungsstücke, zum Beispiel L1h bis Lnh, an die Ausgänge A1 bis An des Schieberegisters 6. Hierbei werden die in Figur 1 noch vorhandenen Kreuzungsstellen der Steuerleitungen L1 bis Ln mit den Datenleitungen DL1 bis DLm vollständig vermieden.

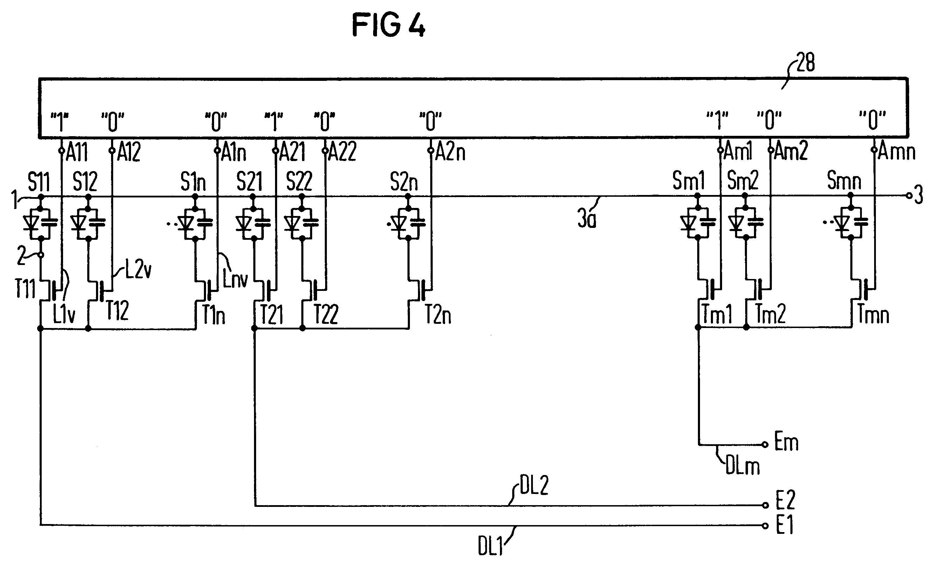

Das in Figur 4 dargestellte Ausführungsbeispiel unterscheidet sich von Figur 3 dadurch, daß anstelle des Schieberegisters 6 (Figur 1) ein Schieberegister 28 vorgesehen ist, das eine der Anzahl der Sensorelemente entsprechende Anzahl von Parallelausgängen A11 bis Amn aufweist. Das Schieberegister 28 erstreckt sich entlang der Reihe der Sensorelemente S11 bis Smn, wobei die Parallelausgänge A11 bis Amn jeweils neben den in Figur 4 gleichbezeichneten Sensorelementen S11 bis Smn angeordnet sind. Daher ist es möglich, die vertikalen Leitungsstücke, zum Beispiel L1v bis Lnv, der Steuerleitungen für die Schalttransistoren T11 bis Tmn unmittelbar mit den Ausgängen A11 bis Amn zu verbinden. Legt man Ausgangssignale "1" an die Ausgänge A11, A21 bis Am1, über die die jeweils ersten Sensorelemente aller m Gruppen angesteuert werden, und belegt alle übrigen Ausgänge von 28 mit "0"-Signalen, so ergibt sich bei einer schrittweisen Verschiebung dieses Ausgangssignalmusters um n Stellen nach rechts die anhand von Figur 1 erläuterte Ansteuerung der Schalttransistoren, ohne daß Überkreuzungen der Steuerleitungen außerhalb des Schieberegisters 28 in Kauf genommen werden müssen. Die Zahl der Überkreuzungen der Steuerleitungen innerhalb des Schieberegisters 28 nimmt überdies nur proportional zur Anzahl der Sensorelemente zu. Weiterhin sind die Steuerleitungen in Figur 4 auch wesentlich kürzer bemessen als die in den Figuren 1 oder 3 dargestellten. Besonders vorteilhaft ist es, das Schieberegister 28 zusammen mit den Sensorelementen, den Datenleitungen und den Steuerleitungen auf dem Substrat 11 zu integrieren.

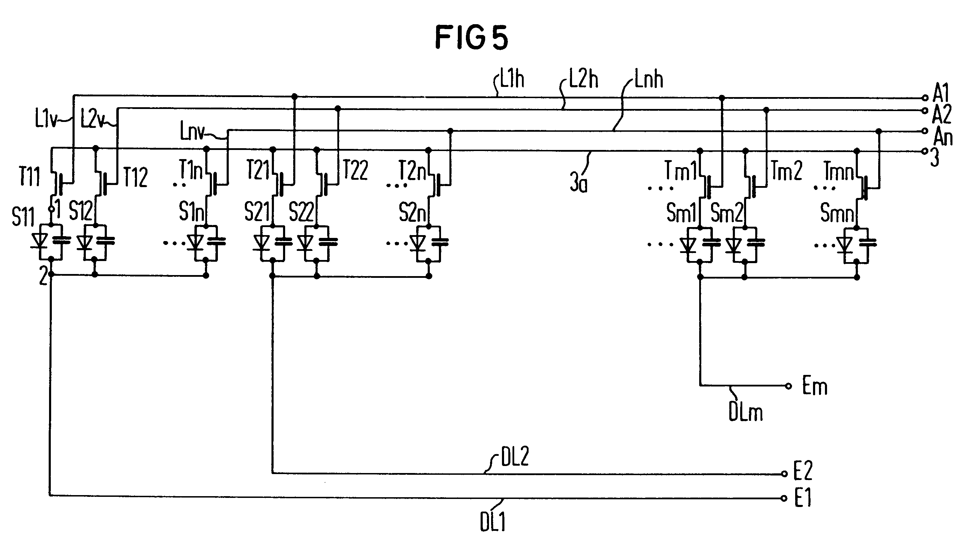

Figur 5 zeigt ein Ausführungsbeispiel, das sich von Figur 3 dadurch unterscheidet, daß die Schalttransistoren, zum Beispiel T11, nicht zwischen den Anschluß 2 des zugeordneten Sensorelementes, zum Beispiel S11, und die zugehörigen Datenleitung, zum Beispiel DL1, geschaltet sind, sondern zwischen den Anschluß 1 des Sensorelementes und die Zuleitung 3a zum gemeinsamen Anschluß 3. Durch diese Maßnahme können die vertikalen Leitungsstücke, zum Beispiel L1v, L2v bis Lnv, der Steuerleitungen für die Schalttransistoren verkürzt werden und brauchen nicht mehr zwischen zwei benachbarten Sensorelementen hindurchgeführt zu werden, wie das bei der Schaltungsanordnung nach Figur 3 der Fall ist. Die Ansteuerung der Schalttransistoren wird dabei so vorgenommen wie bereits anhand von Figur 1 beschrieben.

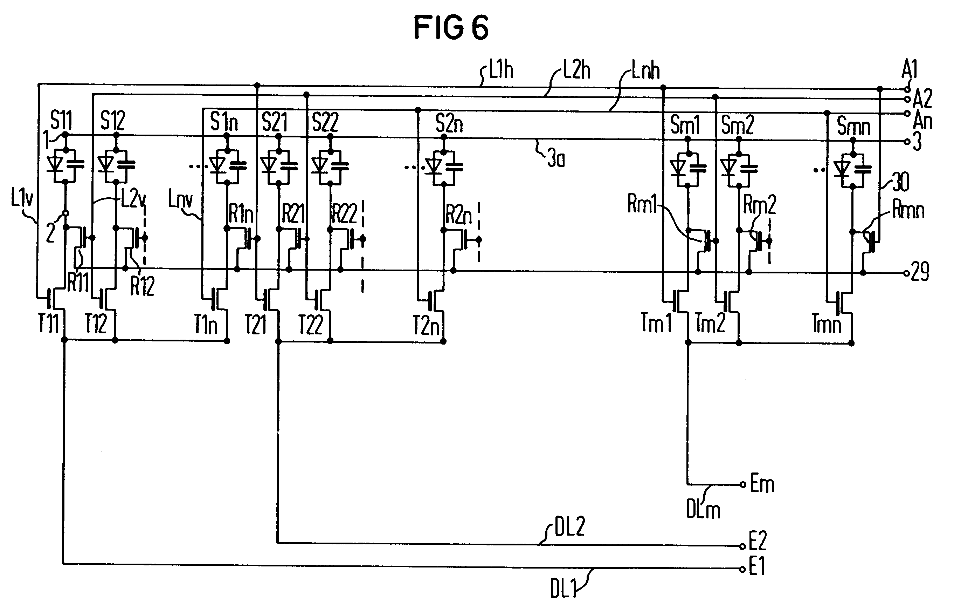

In Figur 6 ist ein Ausführungsbeispiel der Erfindung gezeigt, das eine Weiterbildung der Schaltungsanordnung nach Figur 3 darstellt. Die Sensorelemente S11 bis Smn, Schalttransistoren T11 bis Tmn, Datenleitungen DL1 bis DLm und Steuerleitungen, zum Beispiel L1v, L1h bis Lnv, Lnh, entsprechen in ihrer Anordnung der Figur 3, wobei lediglich die vertikalen Leitungsstücke, zum Beispiel L1v bis Lnv, der Steuerleitungen hier jeweils links von den zugeordneten Sensorelementen, zum Beispiel S11 bis S1n, an diesen vorbeigeführt sind. Die oberen Enden der vertikalen Leitungsstücke sind wie in Figur 3 über die horizontalen Leitungsstücke L1h bis Lnh mit den Ausgängen A1 bis An des Schieberegisters 6 verbunden. Zusätzlich ist der zweite Anschluß, zum Beispiel 2, jedes Sensorelementes, zum Beispiel S11, über einen Rücksetztransistor, zum Beispiel R11, mit einem Anschluß 29 verbunden, der auf Bezugspotential liegt. Die Gates der Rücksetztransistoren R11 bis Rm (n - 1) sind jeweils mit den vertikalen Leitungsstücken der Steuerleitungen für die Schalttransistoren T12 bis Tmn der nachfolgenden Sensorelemente verbunden. Lediglich der Rücksetztransistor Rmn des letzten Sensorelements Smn ist über eine zusätzliche Leitung 30 mit dem Ausgang A1 des Schieberegisters 6 beschaltet. Bei der Schaltungsanordnung nach Figur 3 mußten erst die Auslesephase und die sich hieran anschließende Aufladephase für ein Sensorelement, zum Beispiel S11, abgewartet werden, bevor der zugehörige Schalttransistor, zum Beispiel T11, gesperrt werden konnte und das nächste Sensorelement, zum Beispiel S12, durch Leitendschaltung des zugehörigen Schalttransistors, zum Beispiel T12, ausgelesen werden konnte. Gemäß Figur 6 kann wegen der getrennten Ansteuerung eines jeden Sensorelements für die Zwecke des Auslesens und Rücksetzens unmittelbar nach Beendigung der Auslesephase für ein Sensorelement, zum Beispiel S11, und nach dem Sperren des diesem zugeordneten Schalttransistors, zum Beispiel T11, die Auslesephase für das nächstfolgende Sensorelement, zum Beispiel S12, beginnen, was durch Leitendschaltung des diesem zugeordneten Schalttransistors, zum Beispiel T12, geschieht. Gleichzeitig damit wird das vorhergehende Sensorelement, zum Beispiel S11, über den leitenden Rücksetztransistor, zum Beispiel R11, wieder auf -U₀ aufgeladen. Damit überlappen sich die Aufladevorgänge und die Auslesevorgänge für die Sensorelemente, so daß eine schnellere Auslesung des Bildsensors erfolgt als nach Figur 3.

Figur 7 zeigt eine Schaltung, die die in der beschriebenen Weise sequentiell ausgelesenen Sensorsignale so umsortiert, daß sie in der Reihenfolge der Anordnung der sie erzeugenden Sensorelemente weiter ausgelesen werden können. Zu diesem Zweck ist der Eingang 31 dieser Schaltung über einen Analog/Digital-Umsetzer 32 und über einen Umschalter US1 in der ausgezeichneten Schaltstellung mit dem Datenein-/ausgang 33 eines digitalen Speichers 34 verbunden. Die am Ausgang 5 (Figur 1) abgegebenen Sensorsignale werden dem Eingang 31 zugeführt, in 32 digitalisiert und in die jeweils adressierten Speicherplätze des Speichers 34 eingelesen. Für die Erzeugung der Speicheradressen dienen zwei Zähler 35 und 36, deren Ausgänge mit dem Adresseneingang des Speichers 34 über Leitungen 37 verbunden sind. Dabei wird der Zähleingang des als Gruppenzähler aufzufassenden Zählers 35 mit einer über einen Anschluß 38 zugeführten Zählimpulsfolge Uz beaufschlagt. Jeder Zählimpuls von Uz inkrementiert den Zähler 35 um 1. Sobald der Zähler 35 den Zählerstand m erreicht hat, gibt er einen Zählimpuls über einen Umschalter US3 in der ausgezeichneten Schaltstellung an den Zähleingang des Zählers 36 weiter, der auch als Elementenzähler zu bezeichnen ist. Dieser Impuls inkrementiert den Zähler 36 um 1. Die nächsten m Zählimpulse von Uz inkrementieren wieder den Zähler 35 von 0 auf m, wobei beim Erreichen von m wieder ein Zählimpuls an den Zähler 36 weitergegeben wird. Der Gruppenzähler 35 stellt beim Einlesen der aufeinanderfolgenden Sensorsignale den niederwertigeren Zähler dar, der Elementenzähler 36 den höherwertigen. Die Speicherplätze des Speichers 34 werden über die Leitung 37 in der Weise adressiert, daß der jeweilige Zählerstand von 35 die niederwertigen Stellen des Adressensignals bildet, der jeweilige Zählerstand von 36 die höherwertigen Stellen des Adressensignals.

Das Auslesen der gespeicherten Sensorsignale erfolgt über einen weiteren Umschalter US4 in seiner gestrichelt gezeichneten Schaltstellung, wobei der Datenein-/ausgang 33 beispielsweise über einen Digital/Analog-Wandler 39 mit einem Ausgang 40 verbunden ist. Hierbei genügt es, die Umschalter US2 und US3 in ihre gestrichelt gezeichneten Schaltstellungen zu bringen, um die gewünschte Umsortierung der Sensorsignale zu erreichen. In diesen Schaltstellungen hat nämlich der Zähler 36 die niedrigere Wertigkeit, so daß er durch die bei 38 zugeführten Zählimpulse jeweils um 1 inkrementiert wird. Beim Erreichen des Zählerstandes n gibt der Zähler 36 einen Zählimpuls über eine Leitung 41 und den Umschalter US2 an den Zähleingang des Zählers 35 weiter, der hierdurch um 1 inkrementiert wird. Die Adressierung der Speicherplätze beim Auslesen erfolgt also mit vertauschter Wertigkeit der über 35 und 36 erzeugten Adressenanteile. Dadurch wird erreicht, daß am Ausgang 40 die Sensorsignale der Sensorelemente S11 bis Smn in der Reihenfolge der Anordnung der letzteren auf dem Bildsensor ausgelesen werden.

Die Schaltung nach Figur 7 kann durch einen zweiten Speicher 41, der in entsprechender Weise über Leitungen 42 mit den ausgängen eines Gruppenzählers 43 und eines Elementenzählers 44 adressiert wird, ergänzt werden. Diesen Zählern wird eine Zählimpulsfolge Uz′ über einen Anschluß 45 und Umschalter US5 und US6, jeweils in ihren gestrichelt gezeichneten Schaltstellungen, zugeführt, um über den dann ebenfalls in seiner gestrichelten Stellung befindlichen Umschalter US1 und über eine Leitung 40a die von S11 bis Smn in einer zweiten Ausleseperiode erzeugten Sensorsignale in derselben Weise einzulesen wie bereits anhand des Zählers 34 für die Signale der ersten Ausleseperiode beschrieben wurde. Da sich alle Umschalter US1 bis US6 hierbei in ihren gestrichelt gezeichneten Schaltstellungen befinden, werden die Sensorsignale der ersten Ausleseperiode aus dem Speicher 34 ausgelesen und gleichzeitig die Sensorsignale der zweiten Auslesepierode in den Speicher 41 eingeschrieben. Nach Beendigung dieses Einschreibvorgangs werden die Umschalter US1 bis US6 in ihre ausgezeichneten Schaltstellungen gebracht, wobei dann aus dem Speicher 41 die dort gespeicherten Sensorsignale der zweiten Ausleseperiode an den Ausgang 40 übertragen werden, während die Sensorsignale einer dritten Ausleseperiode, die über den Eingang 31 zugeführt werden, gleichzeitig in den Speicher 34 eingeschrieben werden. Die Frequenzen der Zählimpulse von Uz und Uz′ können übereinstimmen, ohne daß dies jedoch zwingend erforderlich ist.

Da der Bildsensor kontinuierlich Sensorsignale liefert, ist die Schaltung nach Figur 7 mit den Speichern 34 und 41 in der Lage, jeweils aus einem dieser Speicher die Sensorsignale einer Ausleseperiode in der richtigen Reihenfolge auszulesen, während gleichzeitig die Sensorsignale der nächstfolgenden Ausleseperiode in den anderen Speicher eingelesen werden.

In einer vorteilhaften Anwendung eines optoelektronischen Bildsensors nach der Erfindung entspricht die Längenabmessung der auf dem Substrat 11 integrierten Sensorelementenzeile S11 bis Smn der einen Abmessung eines abzutastenden Dokuments, das dann in Richtung seiner anderen Abmessung an dem Bildsensor vorbeibewegt wird. Dabei sind nur einfache, nicht verkleinernde optische Hilfsmittel zwischen der abzutastenden Dokumentenfläche und dem Bildsensor anzuordnen. Der grundsätzliche Aufbau eines in dieser Weise im Rahmen eines Faxgerätes eingesetzten Bildsensors ist dem Toshiba Review No. 149, Herbst 1984, Seiten 33 bis 36 zu entnehmen.

## Patentansprüche

1. Integrierte Schaltung zum Auslesen eines optoelektronischen Bildsensors, der m Gruppen von jeweils n nebeneinander angeordneten, über ihre ersten Anschlüsse (1) mit einem konstanten Potential beschaltbaren Sensorelemente (S11...Smn) aufweist, bei der die zweiten Anschlüsse (2) der Sensorelemente über Datenleitungen (DL1...DLm) mit den Eingängen einer Ausleseschaltung (4) verbindbar sind, bei der in Serie zu jedem Sensorelement ein Schalttransistor (T11...Tmn) angeordnet ist und bei der die Ausleseschaltung (4) die Sensorsignale aller Sensorelemente sequentiell an einen Ausgang (5) überträgt, wobei die n Sensorelemente (S11...S1n) jeder Gruppe über die in Serie zu ihren zweiten Anschlüssen angeordneten Schalttransistoren (T11...T1n) einzeln nacheinander an eine gemeinsame, gruppenspezifische Datenleitung (DL1) anschaltbar sind, ihre ersten Anschlüsse ständig mit dem konstanten Potential belegt sind, wobei die Ausleseschaltung m Eingänge (E1...Em) hat, die mit m gruppenspezifischen Datenleitungen (DL1...DLm) beschaltet sind und wobei die Schalttransistoren (T11...Tm1) derjenigen Sensorelemente (S11...Sm1) unterschiedlicher Gruppen, die innerhalb ihrer Gruppe jeweils gleiche Ordnungszahlen aufweisen, über eine gemeinsame Steuerleitung (L1) ansteuerbar sind, so daß den Eingängen der Ausleseschaltung (4) ein Signalbündel von m Sensorsignalen aller Sensorelemente gleicher Ordnungszahlen gleichzeitig und in n aufeinanderfolgenden Zeitabschnitten jeweils entsprechende Signalbündel, die zu unterschiedlichen Ordnungszahlen gehören, zugeführt werden,
**dadurch gekennzeichnet,**
daß eine Schaltung mit einem ersten Speicher (34) vorgesehen ist, in den die ausgelesenen Sensorsignale einschreibbar sind und der über die Ausgänge eines mit einer Zählimpulsfolge beaufschlagten Gruppenzählers (35) und eines diesem nachgeschalteten Elementenzählers (36) adressiert wird, und daß die eingeschriebenen Sensorsignale in der Weise ausgelesen werden, daß die Zählimpulsfolge dem Elementenzähler (36) zugeführt wird und der Gruppenzähler (35) diesem nachgeschaltet ist, so daß die über die Zählerausgänge erfolgende Adressierung des ersten Speichers (34) mit vertauschter Wertigkeit der Zähler (35, 36) erfolgt.

2. Integrierte Schaltung nach Anspruch 1,
dadurch gekennzeichnet,
daß der Bildsensor eine Mehrzahl von metallischen Elektroden (10) aufweist, die auf einem isolierenden Substrat (11) nebeneinander angeordnet sind, daß die endseitigen Abschnitte der Elektroden (10) von einem Streifen (12) aus photoleitendem Material überdeckt sind, daß der Streifen (12) mit einer transparenten Elektrode (13) belegt ist und daß diese mit einer Konstantspannung beschaltet ist.

3. Integrierte Schaltung nach Anspruch 2,
dadurch gekennzeichnet,
daß die Schalttransistoren (T11) und die Datenleitungen (DL1...DLm) zusammen mit den Sensorelementen (S11...Smn) auf dem isolierenden Substrat (11) integriert sind.

4. Integrierte Schaltung nach Anspruch 1,
dadurch gekennzeichnet,
daß der erste Speicher (34) durch einen zweiten Speicher (41) ergänzt ist, der in entsprechender Weise über einen weiteren Gruppenzähler (43) und einen weiteren Elementenzähler (44) adressiert wird, und daß die Sensorsignale einer zweiten Ausleseperiode in den zweiten Speicher (41) eingeschrieben werden, während die im ersten Speicher (34) gespeicherten Sensorsignale einer ersten Ausleseperiode aus diesem ausgelesen werden.

## Claims

1. An integrated circuit for reading out an optoelectronic image sensor comprising m groups each of n sensor elements (S11...Smn) disposed side by side and adapted to be connected to a constant potential via their first connections (1), wherein the second connections (2) of the sensor elements are connectable via data lines (DL1...DLm) to the inputs of a read-out circuit (4), wherein a switching transistor (T11...Tmn) is disposed in series with each sensor element and wherein the read-out circuit (4) transmits the sensor signals of all the sensor elements sequentially to an output (5), the n sensor elements (S11...S1n) of each group being individually connectable successively to a common group-specific data line (DL1) via the switching transistors (T11..T1n) disposed in series with their second connections, their first connections being constantly at the constant potential, the read-out circuit having m inputs (E1...Em) connected to m group-specific data lines (DL1...DLm) and the switching transistors (T11...Tm1) of those sensor elements (S11...Sm1) of different groups which have like ordinal numbers in each case within their group being controllable via a common control line (L1) so that there are fed to the inputs of the read-out circuit (4) a bunch of m sensor signals from all the sensor elements of like ordinal numbers simultaneously and, in n consecutive time slots, respectively corresponding signal bunches belonging to different ordinal numbers, characterised in that
a circuit is provided which has a first memory (34) into which the read-out sensor signals can be written and which is addressed via the outputs of a group counter (35) receiving a counting pulse train and of an element counter (36) following said group counter (35), and in that the written-in sensor signals are read out by feeding the counting pulse train to the element counter (36) and connecting the group counter (35) downstream thereof so that the addressing of the first memory (34) via the counter outputs takes place with inverted validity of the counters (35, 36).

2. An integrated circuit according to Claim 1, characterised in that the image sensor comprises a plurality of metallic electrodes (10) disposed side by side on an insulating substrate (11), in that the end portions of the electrodes (10) are covered by a strip (12) of photoconductive material, in that the strip (12) is covered with a transparent electrode (13) and in that the latter is connected to a constant voltage.

3. An integrated circuit according to Claim 2, characterised in that the switching transistors (T11) and the data lines (DL1...DLm) are integrated together with the sensor elements (S11...Smn) on the insulating substrate (11).

4. An integrated circuit according to Claim 1, characterised in that the first memory (34) is complemented by a second memory (41) which is addressed correspondingly via another group counter (43) and another element counter (44) and in that the sensor signals of a second read-out period are written into the second memory (41) while the sensor signals of a first read-out period stored in the first memory (34) are read out of the same.

## Revendications

1. Circuit intégré pour la lecture d'un capteur d'image opto-électronique qui présente m groupes de chacun n éléments capteurs (S11...Smn) disposés l'un à côté de l'autre et pouvant être reliés à un potentiel constant par leurs premières bornes (1), circuit dans lequel les secondes bornes (2) des éléments capteurs peuvent être reliées avec les entrées d'un circuit de lecture (4) par l'intermédiaire de lignes de données (DL1...DLm), dans lequel un transistor de commutation (T11... Tmn) est disposé en série avec chaque élément capteur et dans lequel le circuit de lecture (4) transmet séquentiellement à une sortie (5) les signaux de tous les éléments capteurs, étant précisé que les n éléments capteurs (S11...S1n) de chaque groupe peuvent par l'intermédiaire des transistors de commutation (T11...S1n) disposés en série à leurs secondes bornes, être reliés individuellement l'un après l'autre à une ligne de données commune (DL1), spécifique du groupe, leurs premières bornes étant en permanence mises au potentiel constant, et que le circuit de lecture a m entrées (E1...Em) qui sont reliées à m lignes de données (DL1...DLm) spécifiques des groupes et que les transistors de commutation (T11...Tm1) des éléments capteurs (S11...Sm1) des différents groupes qui présentent chacun, à l'intérieur de leur groupe, les mêmes numéros d'ordre, peuvent être commandés par l'intermédiaire d'une ligne de commande commune (L1), de façon que soient amenés aux entrées du circuit de lecture (4), simultanément, un faisceau de m signaux de tous les éléments capteurs de même numéro d'ordre et, en n intervalles de temps successifs, chacun des faisceaux de signaux correspondants qui appartiennent aux différents numéros d'ordre,
caractérisé
par le fait qu'est prévu un circuit comportant une première mémoire (34) dans laquelle peuvent s'inscrire les signaux des capteurs lus et aux adresses de laquelle on accède en fonction des signaux de sortie d'un compteur de groupes (35) actionné par une suite d'impulsions de comptage et d'un compteur d'éléments (36) monté en aval de celui-ci, et par le fait que les signaux de capteurs inscrits sont lus de la façon que la suite d'impulsions de comptage est amenée au compteur d'éléments (36) et que le compteur de groupes (35) est monté en aval de celui-ci, de sorte que l'adressage de la première mémoire (34), effectué en fonction des signaux de sortie des compteurs, se fait avec permutation des indications des compteurs (35, 36).

2. Circuit intégré selon la revendication 1,
caractérisé
par le fait que le capteur d'image présente une pluralité d'électrodes métalliques (10) qui sont disposées l'une à côté de l'autre sur un substrat isolant (11), que les tronçons d'extrémité des électrodes (10) sont recouverts d'un ruban (12) de matériau photoconducteur, que le ruban (12) est recouvert d'une électrodes transparente (13) et que celle-ci est reliée à une tension constante.

3. Circuit intégré selon la revendication 2,
caractérisé
par le fait que les transistors de commutation (T11) et les lignes de données (DL1...DLm), ainsi que les éléments capteurs (S11...Smn) sont intégrés sur un substrat isolant (11).

4. Circuit intégré selon la revendication 1,
caractérisé
par le fait que la première mémoire (34) est complétée par une seconde mémoire (41) aux adresses de laquelle, de façon correspondante, on accède en fonction d'un autre compteur de groupes (43) et d'un autre compteur d'éléments (44), et par le fait que les signaux des capteurs d'une seconde période de lecture s'inscrivent dans la seconde mémoire (41) pendant que les signaux des capteurs d'une première période de lecture, mémorisés dans la première mémoire (34), y sont lus.
